# EUROPEAN PATENT APPLICATION

(11) **EP 4 749 506 A1**
(43) Date of publication of application: **27.05.2026**
(21) Application number: 24306967.1
(22) Date of filing: 25.11.2024
(51) Int. Cl.: G06F 30/20

(54) **SYSTEM AND METHOD FOR AUTOMATIC DIGITAL TWINS DEPLOYMENT**

(71) Applicant: Commissariat à l'Energie Atomique et aux Energies Alternatives, 75015 Paris (FR)
(72) Inventor: NGUYEN, Quang-Duy, 91191 Gif-sur-Yvette Cedex (FR); SIDIBE, Guéréguin-Der Sylvestre, 91191 Gif-sur-Yvette Cedex (FR); DHOUIB, Saadia, 91191 Gif-sur-Yvette Cedex (FR)
(74) Representative: Atout PI Laplace

(57) **Abstract**

A computer implemented method for generating a digital twin deployment package for a physical asset, the method comprising:
- creating a digital model of the physical asset;
- storing the digital model at a dedicated digital models storage location;
- creating a machine-readable code with meta-data related to at least location information of the digital models storage location and connection information for establishing connection between with the physical asset and asset user's host devices, an asset user's host device being a computing device from which a user may monitor a digital twin of the physical asset ; and
- associating the machine-readable code with the physical asset.

## Description

### Field of the Invention

The present invention relates to the field of software and system engineering, and more particularly, the invention relates to the deployment of Digital Twins.

### Background Art

In the modern industry (Industry 4.0 and Industry 5.0), applying Digital Twins (DT) is a new approach to interacting with manufacturing assets (resources, processes, and products). In detail, a DT can bi-directionally exchange data with its corresponding asset. Thus, users can benefit from DTs for many advanced applications, such as interacting with the DT instead of being near the real asset to monitor and control it, or checking the feasibility of an industrial setup before the operation time.

A DT is a set of digital models representing a real-world asset that enables convergence between the physical and digital states at an appropriate synchronization rate.

The widely-known deployment approach uses a computer to create digital models, then build and run them in a binary application. The running application hosts the DT, connects it to the physical asset, and establishes the data exchanges between the asset and its DT. The digital models proposed by a model provider normally follow some standards.

The Asset Administration Shell (AAS) is the standardized digital representation of an asset for the interoperability of Industry 4.0 components organized in Industry 4.0 systems. An asset can be simple production component, production equipment, a machine or a plant at any level of the equipment hierarchy ISA-95. The system designers, the asset users, the applications, the processes and the asset itself can update the information of the AAS during the lifetime of the asset until its disposal.

A drawback of this approach is that it takes time to develop digital models and to configure the connections between DTs and assets. The review of T. A. Abdel-Aty, E. Negri, and S. Galparoli, "Asset Administration Shell in Manufacturing: Applications and Relationship with Digital Twin", IFAC-PapersOnLine, vol. 55, no. 10, pp. 2533-2538, 2022, provides a list of 29 research works that deploy AAS DTs.

There are several widely used methods to get basic meta-data about an asset and to get an URL to download its online resources indirectly. An approach allows using electronic devices to scan Quick-Response (QR) codes. An approach allows using near-field communication (NFC). Another approach allows using Radio-frequency identification (RFID). Still another approach allows using Bluetooth Low Energy (BLE).

In the industry, it can be cited ZVEI, a German Electrical and Electronic Manufacturers' Association, and partners who are developing a Digital Product Passport 4.0 (DDP4.0) standard adopting a same approach. The following papers detail methods where industrial partners assign each device with an identification which is saved on an online space. A QR code is printed on industrial devices that later allows users to get the devices' information with a phone:
- Electro and Digital Industry Association, "Implementing Level 2 of the ZVEI-ShowCase PCF@Control Cabinet," ZVEI, White Paper, 2023;
- D. Wegene, "DPP4.0 is the industrial answer to the regulatory request on DPP," Siemens AG & ZVEI-Speaker-Industrie 4.0, 2022.

A drawback of all these approaches is that the online resources are limited to documents, application installation files, or web pages. However, none provide online information supporting the deployment of digital twin of a product.

It can also be mentioned as technical background, the technology of pairing two devices to establish a connection in today's smartphones and intelligent devices.

Patent EP 1 745 610 B1 titled « Method and Device for Bluetooth Pairing » describes a method for paring devices with Bluetooth. US 20 140 199 972 A1 titled « Cellular Phone Paired With Wireless Communication Device Via Near Field Communication» describes another method for pairing devices with NFC. A network communication after pairing is normally Bluetooth or WiFi. The pairing addresses the connection establishment mission. However, this method has no impact on the data exchange's content.

Thus, in view of the aforementioned drawbacks, there is a need for an improved method to provide digital twins.

The present invention offers a solution to this need.

### Summary of the invention

An object of the present invention is a deployment method to quickly and automatically provide digital twins to end users.

An innovative feature of the present invention relies on a general architecture allowing asset providers to provide physical assets with associated digital twins.

Indeed, an asset provider may distribute a standardized digital representation of a physical (or real) asset, in the form of a model template describing an asset type of the asset and/or a specific model of each instance of the asset. This official distribution from an asset provider allows preventing any third party to provide another unofficial and low-quality digital representation of an asset in lieu of the asset provider.

The digital twin automatic deployment method of the present invention from the end users side allows end users seamlessly using their personal devices to monitor and control an asset through its digital twin.

The invention may be of interest in the industry domain, particularly:
- for workers at a factory who can use a telephone or an industrial equipment with a Human-Machine Interface (HMI) to control and monitor an industrial robot or device, simply by scanning a QR code (or a NFC tag) available on a body or on a screen of a robot; or
- for workers who can easily get information on several industrial equipments to have their associated digital twins, and who can then launch virtual commissioning and feasibility checking, that is, to check in a virtual environment directly from a user device if those equipments can work together before running them physically.

The invention is further of interest for asset providers who sell assets and want to provide more information to describe their assets, i.e. the invention provides a new and fast way to interact with their assets through digital twins. This can provide a competitive advantage in the marketplace.

More generally, the invention may also be of interest in the general life, particularly for users buying new electrical household goods who just have to scan a NFC tag or a QR code of the goods to automatically get information on the buying asset to turn their personal handheld device into a remote control of the electrical household goods.

The automatic deployment of digital twins as proposed by the present invention, allows that, based on information retrieved from a real asset, a digital twin is first created and next that the newly created digital twin allows to automatically establish a connection with the real asset.

Another interesting situation is for users entering a new location, i.e. a building or a city. The present invention allows providing in a touristic point or any information point, a QR code that a user may scan with his/her handheld device, to automatically get a 3D map and/or any other real-time information of the building or of the city.

To achieve the foregoing objects, a system, method and computer program product are provided in the appended claims.

Particularly, a computer implemented method for generating a digital twin deployment package for a physical asset, comprises:
- creating a digital model of the physical asset;
- storing the digital model at a dedicated digital models storage location;
- creating a machine-readable code with meta-data related to at least location information of the digital models storage location and connection information for establishing connection between with the physical asset and asset user's host devices, an asset user's host device being a computing device from which a user may monitor a digital twin of the physical asset ; and
- associating the machine-readable code with the physical asset.

The invention further provides a storage medium having stored thereon a computer program which, when executed by a processor, implements a method of generating a digital twin deployment package for a physical asset according to the method claims.

Another object of the invention is a computing device, comprising: a processor and a memory, the memory being connected with the processor and being used for storing programs; the processor being configured to implement the method of generating a digital twin deployment package for a physical asset according to the method claims by running a program stored in the memory.

The present invention further provides a method for deploying a digital twin of a physical asset, the physical asset being acquired by an asset user, the method being operated from a host device of the asset user, the host device being a computing device from which the asset user may monitor a digital twin of the physical asset. The method comprises the steps of:
- scanning a machine-readable code attached to the physical asset, wherein the machine-readable code being created according to the steps of the method of generating a digital twin deployment package for a physical asset;
- downloading on the host device a digital model associated to the physical asset automatically from the reading of meta-data of location information of digital models storage location repository address integrated in the machine-readable code;
- configuring the digital model with configuration parameters of the physical asset issued from the reading of the machine-readable code; and
- loading and running a digital twin of the physical asset from the configured digital model.

Further aspects of the invention will now be described, by way of preferred implementation and examples, with reference to the accompanying figures.

### Brief description of the drawings

The above and other items, features and advantages of the invention will be better understood by reading the following more particular description of the invention in conjunction with the figures wherein:
Fig. 1 shows a general system environment for operating the deployment method of the present invention in an example;
Fig. 2 shows a sequence diagram of the deployment method in an embodiment of the present invention;
Fig. 3 is a flow chart illustrating steps for creating a digital twin deployment package according to an embodiment of the present invention;
Fig. 4 is a screenshot of a graphical user interface from a digital model design tool according to an embodiment of the present invention;
Fig. 5 shows a screen shot of a part of a description of an AAS-model for a led scripted in UML in an embodiment of the present invention; and
Fig. 6 is a flow chart of steps for operating a digital twin of a physical asset from a host device of an asset user according to an embodiment of the present invention.

### Detailed description of the invention

In the context of the present invention, several terms used throughout the description are defined as below:
- A Digital Twin (DT) is a digital representation of a physical asset, product or object. A digital twin is a digitally enhanced representation of a physical object, such as airplane, ship, car, television, domestic appliance, plant, etc. A digital twin can be used for a variety of purposes, including remote monitoring, condition monitoring, testing and validation.
- A Digital Model (DM) is a digital representation of an object or of a part of an object.

It can be considered that there are three important parts in a digital twin of an object:
- one or several digital model(s) of the object;
- an evolving set of data relating to the object; and
- means of dynamically updating or adjusting the digital model(s) in accordance with the evolution of data.

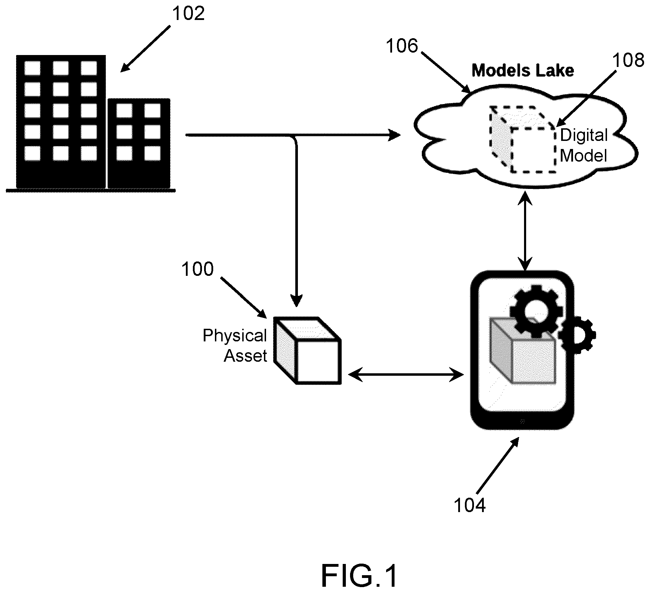

Going first to figure 1, a general system environment for operating the digital twin (DT) deployment method of the present invention is illustrated.

An asset (i.e. a physical product or real object) 100 may be manufactured and further provided by an asset provider 102.

In an embodiment, the manufacturer of an asset may be the same entity than the provider of the asset.

A physical asset is provided with a set of meta-data that can be shared with a computing device 104 which is able to acquire or read meta-data.

The computing device is any kind of computing device from which a user or a costumer who has acquired a physical asset may wish to operate a digital twin. The computing device may be a portable computing device in the form of a notebook or a laptop computing device or a tabletop computing device including a touchscreen, camera, microphone, and loudspeaker, or a smartphone, or a desktop computing device.

In the context of the deployment method of the present invention, the computing device 104 is designated as a "host device" 104.

Generally, meta-data can be shared with devices through a technical convention, and following this technical convention, a computing device can read the meta-data.

Depending on the context, an asset provider may decide which convention is best appropriate regarding precise details such as a mode, a size of payload...

Some well-known and widely adopted conventions may be used to provide, i.e. to embed meta-data, such as QR (Quick Response) code or NFC (Near Field communication). However, alternate method may be used such as RFID (Radio-frequency identification) or BLE (Bluetooth Low Energy).

For a QR code approach, a QR code is attached on an interface of a physical asset. In an embodiment, a QR code may contain a maximum of 2953 Bytes (in the version 40 which has the biggest capacity) which is equal to 2953 characters in the UTF-8 and ASCII format, which is enough to embed the meta-data. A computing device must be equipped with a camera and a QR code reader program.

For a NFC approach, an NFC tag is attached to the physical asset. In an embodiment of an NFC type 5 version, a tag may contain 65536 Bytes which is enough to declare the meta-data. In alternate embodiments, a computing device can use a peer-to-peer mode with a physical asset if this is supported. A computing device must be NFC-enabled to read an NFC tag in reader mode.

For a RFID approach, a physical asset has a RFID tag attached to it. The RFID tag can share data from 64 Bytes up to few MB based on its current mode and version. A computing device must be equipped with a RFID tag reader.

For a BLE approach, a physical asset has a BLE tag attached to it. The BLE tag can share data having 31 to 512 Bytes length. A computing device must be configured with a Bluetooth version 4.0 or later.

Back to figure 1, the host device 104 is further configured (i.e. comprise appropriate means) to interact with a digital space 106, also designated as a "Models Lake", which is a central repository to store digital models 108 of physical assets.

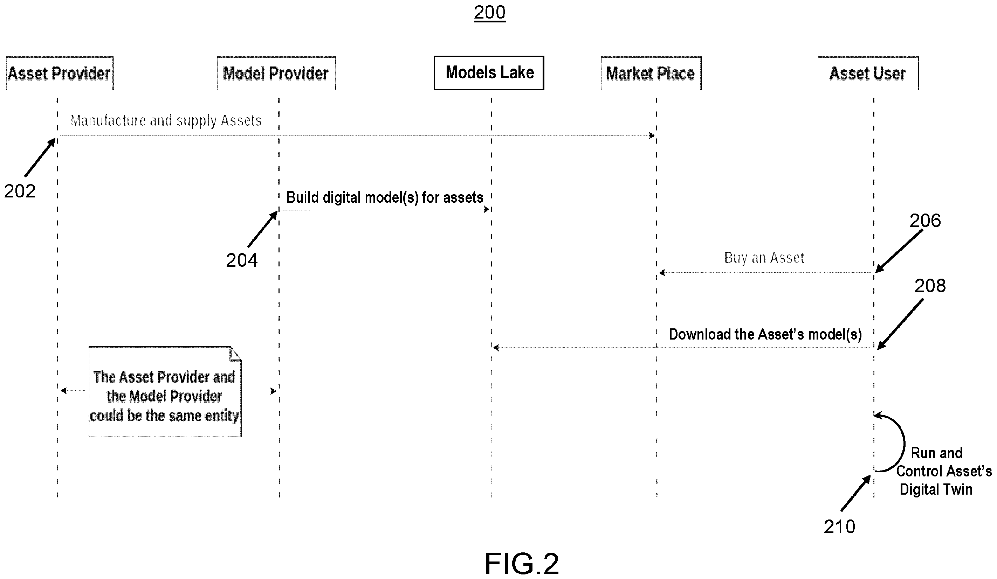

Figure 2 shows a sequence diagram of the deployment method in an embodiment of the present invention.

In a first step 202, a manufactured asset with meta-data related to the asset is supplied by an Asset Provider. Manufactured assets are generally available directly from an asset provider or from third entities within a Market Place.

Once an asset is manufactured, on a next step 204, a digital model of the asset is built based on specifications provided by a Model Provider.

The resulting digital model is push to a Models Lake.

Digital models are transmitted to Models Lake by third parties willing to build digital twins for physical objects. Such third parties contributing to a Models Lake may be a private product provider or any party from a community. For example, a television manufacturer creating a smart television should also provide and store a digital model of the television in a Models Lake shared by several other contributing parties.

Digital models of a Models lake are either freely available to public or with limited access.

Advantageously, digital models are used by (end) users to generate a digital twin of a corresponding physical asset in order to control the latter one.

In an embodiment a digital model is stored as a AAS model, i.e. as a model structured to conform to the AAS standard.

In various implementations, the AAS digital models may be structured in different file formats and language to encode information, such as the known UML, AASX, AutomationML, RDF, JSON, to name a few.

As one known, the unified modeling language (UML) is a general-purpose visual modeling language that is intended to provide a standard way to visualize the design of a system.

A digital model may also be a 3D model structured as different file formats and language to encode information, such as FBX, OBJ, DAE, STL, 3DS, SKP, BLEND to name a few.

Back to figure 2, in a further step 206, an Asset User may acquire or purchase an asset, either from a market place or from an asset provider.

In a next step 208, the user from a user's host device may automatically download a digital model of the asset from a Models Lake, and in a next step 210, a digital twin of the physical asset is automatically built at the host device of the user, to thereby allow the user directly monitoring and controlling the digital twin.

So, an asset or model provider who may want to provide a digital model of a physical asset for a later use of a digital twin by asset users prepares a DT deployment package.

The DT deployment package of an asset may comprise (a) storage information to store digital model(s) of the asset; (b) machine-readable code with meta-data related with the asset; and (c) an application to be run on a host device of asset users, the application comprising software instructions to run a digital twin of the physical asset.

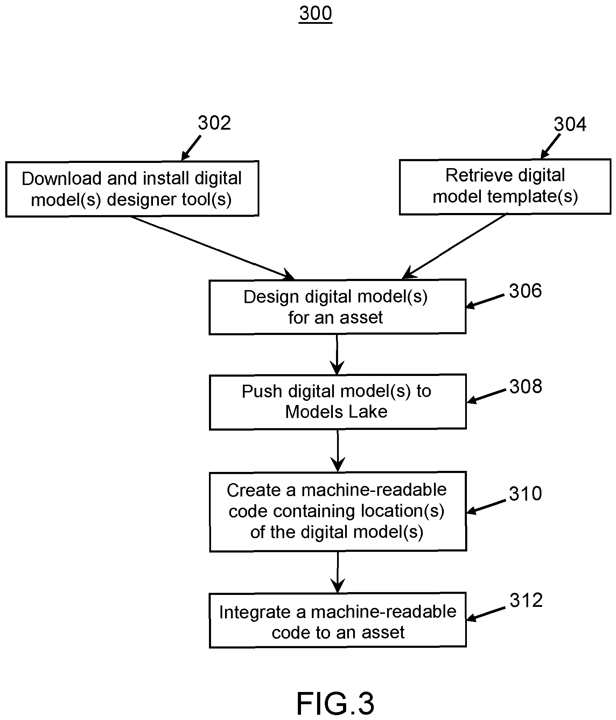

Figure 3 is a flow chart illustrating steps for creating a digital twin deployment package according to an embodiment of the present invention.

A first phase of the process is to generate storage information where digital model(s) of one or several assets are stored. The process 300 begins with a first step 302 of downloading a digital model designer tool and installing the tool on a designer's computer or on specialized devices, if such tool does not already exist on a designer's computer.

Optionally, step 304 shows an operation to retrieve existing digital model template(s), from the Internet or from other locations such as local storage of the designer.

Next step 306 allows creating with a digital model design tool, digital model(s) with information related to the asset(s).

Different model design tools may be used for designing a digital model, such as the "Papyrus4Manufacturing" tool or the "AASX Package Explorer" one to name some.

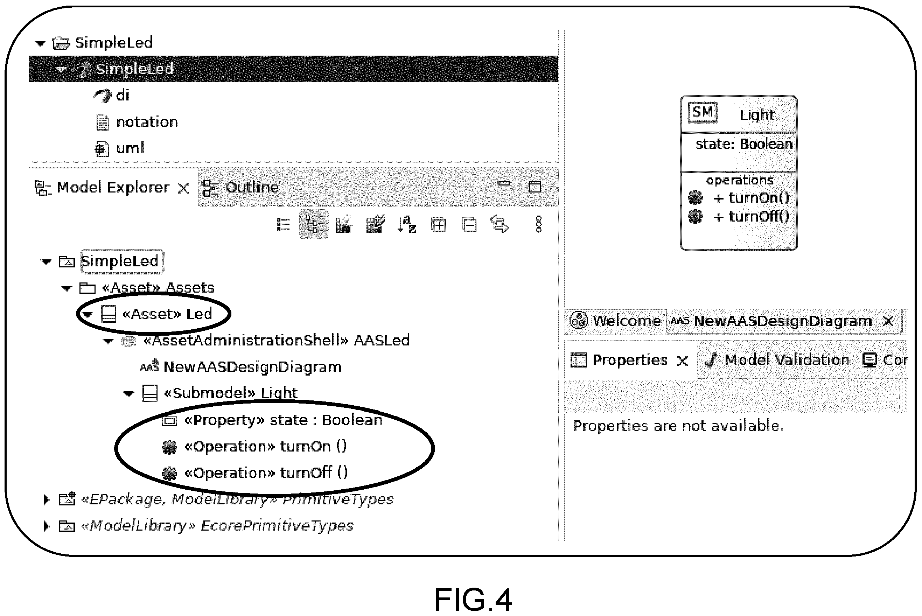

Figure 4 is a screenshot of a graphical user interface (GUI) for designing a digital model with the "Papyrus4Manufacturing" design tool.

For the purpose of a clear description only and not as a limitation, a simplified example is described for a physical asset being a "Led", which is to be modeled as a simple digital model. However, it is to be appreciated that the concepts and principles of the present invention as further described may apply to any other simple physical asset or to complex physical asset that may be represented by several digital models representing different parts of the physical asset.

The GUI on figure 4 shows a visualizable AAS model of a led. In this simple example, the led has a Boolean "Property" State and two operations "TurnOn" and "TurnOff".

Once completed, a AAS digital model is saved as a UML file, in a form of *"aas-model-led.uml*" for the example of the led describing the States properties of the Led.

Each AAS model file is structured to describe an aspect of a physical asset. In the example, the "aas-model-led" file represents operational aspect of the led.

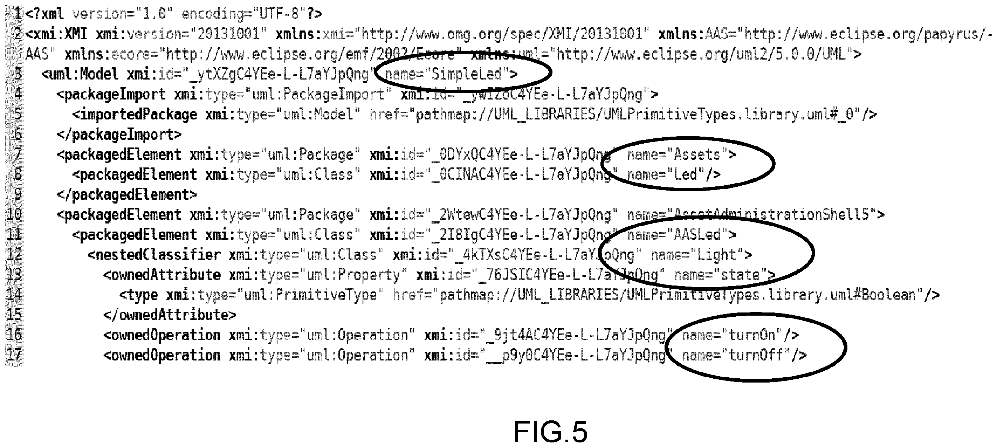

Figure 5 shows an extract of a AAS digital model for the exemplified "aas-model-led" encoded in an XML format inside an UML file. For illustration, some of the led characteristics (aspects) are highlighted in different circles.

As one known, the unified modeling language (UML) is a general-purpose modeling language that is intended to provide a standard way to visualize the design of a system.

Back to figure 3, step 306 further allows providing a 3D digital model of the asset (i.e. of the Led in the example) with a 3D model design tool and saving as a "stl" file.

In alternate embodiments, different 3D model design tools may be used for designing a 3D digital model, such as "Blender", "FreeCAD", "Autodesk Maya", "Autodesk 3ds Max", to name some.

Each 3D model file, i.e. "u3d-model-led" file, represents visual aspect of a physical asset.

Once completed, in a next step 308, AAS model file(s) and optionally a 3D model file(s) are stored in a digital models repository.

In an embodiment, the digital models repository may be an online repository with a dedicated address to store one or several models of a class of physical assets.

For example, the online digital models repository may be a Models Lake located at a dedicated storage address such as the following network address http://192.168.56.8:6080.

The AAS model file of the Led may be pushed at a storage address http://192.168.56.8:6080/file/aas-model-led.uml, and the 3D model file of the Led may also be pushed at the same storage address http://192.168.56.8:6080/file/u3d-model-led.stl.

In another embodiment, the digital models repository may be a local repository.

In another embodiment, the online digital models repository may be an existing Models Lake with an existing address to which a model provider may be one among a plurality of contributors.

Back to figure 3, a second phase of the process allows generating on step 310 a machine-readable code with meta-data associated with the asset.

In various embodiments, the machine-readable code may be in the form of QR code or NFC flag or RFID flag or BLE flag.

In an embodiment, the meta-data of the machine-readable code comprise at least:
- a field to provide location information as a link to download digital models associated with the physical asset, i.e. address(es) where digital model(s) is (are) stored in a digital model repository or in a Models Lake;
- a field to provide connection information to allow establishing a connection between the host device and the physical asset. The connection information may be a network protocol (e.g. HTTP/REST), a port to connect to the host device (e.g. 1234), an IP address.

Optionally, the meta-data may further comprise additional data that can be required (a) to configure the digital model (e.g. a DT's identifier, policies, working mode) and (b) to establish the connection between the digital model and the physical asset (e.g. security information, WiFi SSID, a guide for connection establishment).

After the step of generating a machine-readable code, the process allows in a next step 312 integrating or associating a machine-readable code with a physical asset.

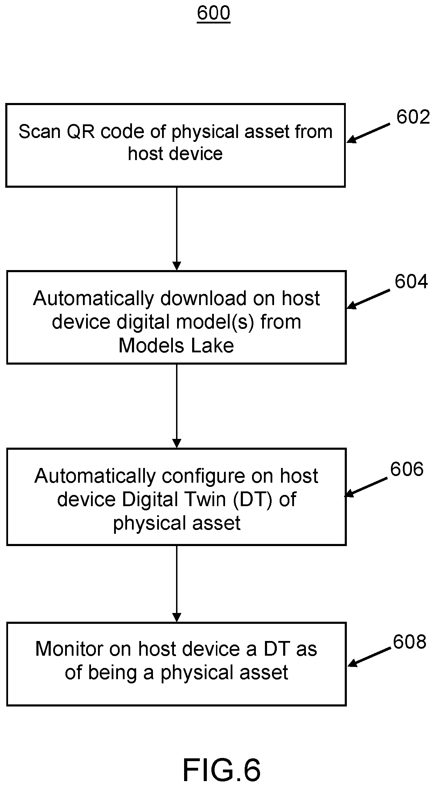

In an embodiment, a QR code which will be later scanned by an asset user as further described with reference to figure 6, may be printed and pasted on a physical asset.

The DT deployment package further comprises providing (c) a DT application to run on asset user's host devices for allowing the automatic configuration of a digital model, thereby creating a digital twin of the physical asset.

Figure 6 is a flow chart of steps 600 for operating a digital twin of a physical asset from a host device of an asset user according to an embodiment of the present invention.

The DT application to be run on a user's host device comprises software instructions to automatically execute a sequence of tasks to allow the user monitor a digital twin from the host device.

In an embodiment, the DT application allows running a script file that automatically executes the following actions:
- step 602: open a camera of the user's host device and scan a QR code attached / linked to a physical asset;
- step 604: download a digital model associated to the physical asset directly from reading a repository address integrated in the QR code, and save it on the host device;
- step 606: configure the digital model with configuration parameters of the physical asset issued from the QR code;
- step 608: load and run a digital twin of the physical asset from the configured digital model. In the example of the led, the AAS DT is automatically connected to the led. The script allows opening a front-end application, and the user can interact with the DT through a GUI of this application. The user can check the state of the led or make a command such as turn on and turn off the led.

The exchange of data between the digital twin and the physical asset may depend on the communication method defined by the physical asset.

Some examples of communication methods may be:
- Bluetooth if the meta-data of the physical asset define that the DT must communicate through Bluetooth;
- WiFi if the physical asset is a hotspot that diffuses a WiFi network or if the physical asset having a mechanism to be configured or autoconfigured to join to a local Wifi network and regenerate a machine-readable code as described with reference to step 310.
- Wired link if the physical asset requires a cable for communicating. In this case, an optional field of metadata would include a link to access a guide to use a cable.

The process described in reference to figure 6 shows the view of product users.

In another general example of a physical asset being a smart television produced by a manufacturer who may also produce various different products such as smartphones, household goods, electric cars. The manufacturer may create its own Models Lake and provide for each product an AAS model in the UML format and a 3D model in the STL format. The manufacturer may also propose an application that can turn any smartphone or tablet into a DT host device.

After buying a television, a costumer can download and install the application proposed by the manufacturer on a smartphone. At the beginning, the new installed application contains no model. The costumer turns on the television and let it connect to the local wireless network at his/her house (e.g. 192.168.56.0/24). When the connection is successful, the television may show a QR code on the screen. The costumer uses the application on the smartphone to read the QR code (step 602). The QR code may contain the following information:
- an address of the television's AAS model stored on the manufacturer's Models Lake;
- an address of the television's 3D model stored on the manufacturer's Models Lake;
- a Network protocol to connect to the television : HTTP/REST for example;
- an IP Address of the television in the house: "192.168.56.100" for example;
- a Port to connect to the television: "5678" for example.

The two models (AAS and 3D) are downloaded (step 604) on the smartphone and shown on the application. When the costumer clicks to configure the digital twin (step 606), then the digital twin allows the costumer to control the television (step 608) and the 3D DT allows mimicking the physical television in the smartphone application.

The present invention may be a method and/or a computer program product at any possible technical detail level of integration. The computer program product may include a computer readable storage medium (or media) having non transitory computer readable program instructions thereon for causing a processor to carry out aspects of the present invention. The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing.

The advantages of the DT deployment method of the present invention may be summarized as:
- allowing a deployment of a digital twin of any physical asset quickly and automatically.
- avoiding security issues. No risk of malware or virus since the application to deploy digital models is preinstalled on host device. It is to be noted that the application must be installed beforehand, proposed and verified by a "credible" entity.
- the networking method between the host device and the asset is not limited. If the host device supports multiple networking methods, the communication between the host device and the asset would depend only on which one is defined in the metadata of the asset.

The present invention has been described in detail with reference to embodiments thereof and examples. Variations and modifications may be effected on the same principles and concepts.

## Claims

1. A computer implemented method (300) for generating a digital twin deployment package for a physical asset, the method comprising:
- creating (306) a digital model of the physical asset;
- storing (308) the digital model at a dedicated digital models storage location;
- creating (310) a machine-readable code with meta-data related to at least location information of the digital models storage location and connection information for establishing connection between the physical asset and asset user's host devices, an asset user's host device being a computing device from which a user may monitor a digital twin of the physical asset ; and
- associating (312) the machine-readable code with the physical asset.

2. The computer implemented method of claim 1 wherein the step of creating a digital model comprises a previous step (302) of installing a digital model design tool on a computer device and designing a digital model with the digital model design tool.

3. The computer implemented method of claim 1 or 2 wherein the step of creating a digital model comprises the step of creating an Asset Administration Shells (AAS) digital model.

4. The computer implemented method of anyone of claims 1 to 3 wherein the step of creating a digital model further comprises the step of creating a 3D digital model of the physical asset.

5. The computer implemented method of anyone of claims 1 to 4 wherein the step of storing the digital model further comprises the step of storing the digital model at an online Models Lake.

6. The computer implemented method of anyone of claims 1 to 5 wherein the step of creating a machine-readable code for embedding the meta-data comprises the step of creating a QR code or a NFC flag or a RFID flag or a BLE flag.

7. The computer implemented method of anyone of claims 1 to 6 further comprising a step of providing an application to run on asset user's host devices for allowing the configuration of the digital model to thereby creating a digital twin of the physical asset.

8. The computer implemented method of anyone of claims 1 to 7 wherein the step of creating a digital model comprises a previous step (304) of retrieving a digital model template of the physical asset.

9. A storage medium having stored thereon a computer program which, when executed by a processor, implements a method of generating a digital twin deployment package for a physical asset according to anyone of claims 1 to 8.

10. A computing device, comprising: a processor and a memory, the memory being connected with the processor and being used for storing programs; the processor being configured to implement the method of generating a digital twin deployment package for a physical asset according to anyone of claims 1 to 8 by running a program stored in the memory.

11. A method for deploying a digital twin of a physical asset, the physical asset being acquired by an asset user, the method being operated from a host device of the asset user, the host device being a computing device from which the asset user may monitor a digital twin of the physical asset, the method comprising:
- scanning a machine-readable code attached to the physical asset, wherein the machine-readable code being created according to the steps of the method of generating a digital twin deployment package for a physical asset according to anyone of claims 1 to 8;
- downloading on the host device a digital model associated to the physical asset automatically from the reading of meta-data of location information of digital models storage location repository address integrated in the machine-readable code;
- configuring the digital model with configuration parameters of the physical asset issued from the reading of the machine-readable code; and
- loading and running a digital twin of the physical asset from the configured digital model.

12. A storage medium having stored thereon a computer program which, when executed by a processor, implements a method of deploying a digital twin of a physical asset according to claim 11.

13. A computing device, comprising: a processor and a memory, the memory being connected with the processor and being used for storing programs; the processor being configured to implement the method of deploying a digital twin of a physical asset according to claim 11 by running a program stored in the memory.
